# EUROPEAN PATENT APPLICATION

(11) **EP 4 586 311 A1**
(43) Date of publication of application: **16.07.2025**
(21) Application number: 25150563.2
(22) Date of filing: 07.01.2025
(51) Int. Cl.: H01L 23/13, H01L 23/373, H01L 23/15, H01L 23/495, H01L 23/498, H01L 23/538, H01L 23/544, H01L 25/07

(54) **MULTILAYER SUBSTRATES, POWER MODULES, AND ELECTRICAL SYSTEMS**

(30) Priority: 09.01.2024 CN 202410037907; 26.12.2024 US 202419002329
(71) Applicant: Shenzhen STS Microelectronics Co., Ltd., Shenzhen 518048 (CN)
(72) Inventor: CHEN, Qiao, SHENZHEN, 518040 (CN); ZHENG, Nan Nan, SHENZHEN, 518038 (CN); LIANG, Lin, SHENZHEN, 518048 (CN)
(74) Representative: Casalonga

(57) **Abstract**

The present disclosure relates to a multilayer substrate, a power module, and an electrical system. A multilayer substrate is provided that comprises: an insulating material layer including a ceramic material; a first metal layer attached to the insulating material layer on a side of the insulating material layer; and a second metal layer attached to the insulating material layer on an opposite side of the insulating material layer, wherein the insulating material layer is configured as a plurality of segments separated from each other, a first portion of the second metal layer, for attaching a chip thereon, overlapping at least one segment of the insulating material layer.

## Description

### Technical field

The present disclosure relates to a multilayer substrate, a power module, and an electrical system.

### Background

Packages of Power modules such as Intelligent Power Modules (IPM) are receiving more and more attention. In IPM packages, power-side devices are mounted on multi-layer substrates, such as Direct Bond Copper (DBC) substrates, so as to improve heat dissipation performance and provide electrical connections.

A multi-layer substrate such as a DBC substrate includes two metal layers attached to opposite surfaces of an insulating material layer (such as a ceramic sheet). Multilayer substrates undergo various thermal processes in the preparation of IPMs, and may also experience application scenarios with relatively high temperatures in practical use. Due to the different coefficients of thermal expansion (CTE) between the metal layers and the insulating material layer, such as ceramic, such multilayer substrates such as DBC substrates have significant stress and strain, which reduces the reliability and robustness of the power modules.

Power modules, on the other hand, need to be molded by encapsulation process. One approach is transfer molding. The conventional Transfer Molding Module (TMM) uses a retract pin to prevent swirling and overflow of liquid resin during the molding process. However, such process inevitably leaves several blind holes after resin is cured. The blind hole area is considered to be of insufficient thickness and may result in leakage or abnormal discharge.

Therefore, there is a need of improved packages and the manufacturing methods (packaging methods) thereof in the related arts.

### Brief Summary

According to one aspect of the present disclosure, there is provided a multilayer substrate, comprising: an insulating material layer including a ceramic material; a first metal layer attached to the insulating material layer on a side of the insulating material layer; and a second metal layer attached to the insulating material layer on an opposite side of the insulating material layer, wherein the insulating material layer is configured as a plurality of segments separated from each other, and wherein a first portion of the second metal layer, for attaching a chip thereon, overlaps at least one segment of the insulating material layer.

In some embodiments, the second metal layer further comprises: a second portion extending from the first portion and beyond the insulating material layer, the second portion having at least one first opening, wherein a projection of the at least one first opening on a plane in which the insulating material layer is located does not overlap the insulating material layer, and wherein the at least one first opening has a shape matching a shape of a corresponding portion of a clamping tool such that the at least one first opening is capable of firmly engaging the clamping tool.

In some embodiments, the at least one first opening comprises: at least two first notches extending inward from edges of a second portion of the second metal layer and located on two opposite sides of the second metal layer respectively, wherein length directions of the segments of the insulating material layer are substantially parallel to the two opposite sides of the second metal layer.

In some embodiments, the second metal layer comprises a plurality of segments separated from each other, one or more of the segments of the second metal layer each comprise a chip attachment portion as at least a portion of the first portion and a lead attachment portion extending from the chip attachment portion, and each segment of the second metal layer is attached to a corresponding segment of the insulating material layer.

In some embodiments, the chip attachment portion is attached to a corresponding segment of the insulating material layer, and the lead attachment portion is attached to the corresponding segment and another adjacent segment.

In some embodiments, the first metal layer and the second metal layer are attached to the insulating material layer by sintering, brazing, soldering or curing.

In some embodiments, the first metal layer comprises: a first portion overlapping the insulating material layer; and a second portion extending from the first portion and beyond the insulating material layer, the second portion having at least one second opening extending inward from an edge of the second portion, wherein at least one of both of each first opening and a corresponding second opening has a shape matching a shape of a corresponding portion of a clamping tool, such that it is capable of firmly engaging the clamping tool.

In some embodiments, a vertical projection of each second opening on a plane in which the second metal layer is located overlaps at least a portion of a corresponding first opening of the second metal layer for engaging the clamping tool.

In some embodiments, the at least one second opening comprises: at least two second notches that are disposed on opposite sides of the first metal layer respectively, wherein a vertical projection of each second notch on a plane in which the second metal layer is located falls in a corresponding first notch of the second metal layer, and wherein at least one notch of both of each first notch and a corresponding second notch has a shape matching the shape of the corresponding portion of the clamping tool, such that the at least one notch is capable of firmly engaging the clamping tool.

In some embodiments, the first metal layer is integral and is isolated from the second metal layer.

In some embodiments, a width of an open edge of the first notch is greater than a width of an inner portion of the first notch in a direction parallel to the open edge, and a width of an open edge of the second notch is greater than a width of an inner portion of the second notch in a direction parallel to the open edge.

In some embodiments, a width of an open edge of the first notch is less than a width of at least a portion of an inner portion of the first notch in a direction parallel to the open edge, and a width of an open edge of the second notch is less than a width of at least a portion of an inner portion of the second notch in a direction parallel to the open edge.

In some embodiments, the first notch comprises two inner edges extending inward facing each other, the second notch comprises two inner edges extending inward facing each other, and each inner edge of the first notch and the second notch is configured such that: with respect to an axis passing through an innermost point of the inner edge and parallel to a direction in which the respective notch extends inward, the inner edge has a slope gradually decreasing as the inner edge extends toward the innermost point.

In some embodiments, each inner edge has one of the following shapes: an arc which is not continuously differentiable; or a plurality of line segments connected in sequence and having discontinuous slopes.

In some embodiments, the inner edges of the first notch of the first metal layer are arc-shaped, and the inner edges of the second notch of the second metal layer are arc-shaped.

In some embodiments, the first notch is a portion of a circle or ellipse and the second notch is a portion of a circle or ellipse; or the first notch is a trapezoid, a square, a rectangle, or a combination thereof, and the second notch is a trapezoid, a square, a rectangle, or a combination thereof.

In some embodiments, the substrate is a DBC substrate, an AMB substrate, a DBA substrate, or an IMS substrate.

According to another aspect of the present disclosure, there is provided a power module, comprising: a substrate according to any embodiment of the present disclosure; and the chip comprising a power semiconductor device, wherein the chip is attached to a first portion of a second metal layer of the substrate.

In some embodiments, the power module further comprises: a lead frame comprising a lead attached to the second metal layer; and a mold compound encapsulating at least a portion of the substrate, the chip, and at least a portion of the lead frame; wherein a portion of the second metal layer having the lead attached thereto is attached to a corresponding segment of the insulating material layer, and wherein the mold compound exposes a surface of the first metal layer of the substrate which is away from the chip.

According to another aspect of this disclosure, there is further provided an electrical system including the power module according to any embodiment of the present disclosure.

Other features and advantages of the present disclosure will become apparent from the following detailed description of exemplary embodiments of the present disclosure with reference to the accompanying drawings.

### Brief Description of the Drawings

The accompanying drawings, which are incorporated in and constitute a portion of this specification, illustrate embodiments of the present disclosure and, together with the description, serve to explain the principles of the present disclosure.

The present disclosure will be more clearly understood from the following detailed description with reference to the accompanying drawings, in which:
FIG. 1 shows a schematic top view of a substrate according to some embodiments of the present disclosure;
FIG. 2 shows a schematic top view, from another perspective, of a substrate according to some embodiments of the present disclosure;
FIG. 3 shows a schematic diagram of a power module according to some embodiments of the present disclosure;
FIG. 4 shows a schematic diagram of a power module according to some embodiments of the present disclosure;
FIGS. 5A-5D are schematic diagrams showing the shapes of notches according to some embodiments of the present disclosure.

Note that in the embodiments described below, the same reference numeral is sometimes used in various drawings to represent the same part or the part with the same function, and its repetitive explanation is omitted. In this description, similar reference numerals and letters are employed to denote similar elements/items in the accompany drawings, and therefore, once an item is defined in a drawing, there is no need for further discussion of the same in the subsequent drawings.

For ease of understanding, the positions, dimensions, and ranges of structures shown in the drawings may not necessarily represent the actual positions, dimensions, and ranges. Therefore, embodiments of the present disclosure shall not be limited to the positions, dimensions, and ranges or the like disclosed in the accompanying drawings.

### Detailed Description

Various exemplary embodiments of the present disclosure will now be described in detail with reference to the accompanying drawings. Notice that, unless otherwise specified, the relative arrangements, numerical expressions and values of the components and steps set forth in these example embodiments shall not limit the scope of the disclosure. Techniques, methods, and apparatuses known to those of ordinary skills in the related art may not be discussed in detail, but where appropriate, these techniques, methods, and apparatuses should be considered as part of the specification.

The following description of at least one exemplary embodiment is in fact merely illustrative and is not intended in any means to be limiting for the embodiments of the disclosure, its applications or uses. It should also be understood that any exemplary embodiment described herein does not necessarily to be preferred or advantageous over other embodiments. The present disclosure is not intended to be bound or limited by any expressed or implied theory presented in the preceding technical field, background, or summary or the following detailed description.

Additionally, certain terms may be used in the following description for reference purposes only, and therefore not intended to be limiting. For example, unless explicitly stated by or in the context, the terms "first", "second" and other such numerical terms referring to structures or elements do not indicate or imply any sequence or order.

It is also to be understood that the terms "comprise/include" or their variants, when being used herein, are intended to state that the stated feature, integer, step, operation, element, and/or component is present, but do not preclude the presence or addition of one or more other features, integers, steps, operations, elements, and/or components and/or a combination thereof.

In this description, the term "chip" includes, but is not limited to, wafer or die. Unless the context clearly indicates otherwise, the term "overlap" means at least partially overlap.

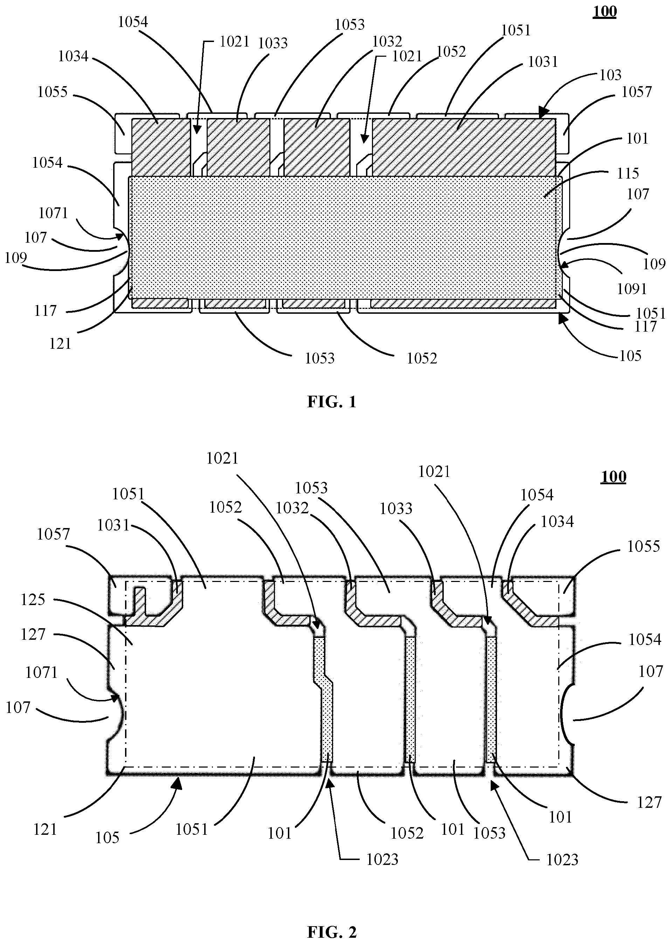

FIG. 1 shows a schematic top view of a substrate according to some embodiments of the present disclosure viewed from one side thereof. FIG. 2 shows a schematic top view of the substrate according to some embodiments of the present disclosure viewed from the other side. The following description will be given with reference to FIGS. 1 and 2.

As shown in FIG. 1, the substrate 100 may include a first metal layer 101, an insulating material layer 103, and a second metal layer 105. The first metal layer 101 is disposed on a side of the insulating material layer 103 (such as its lower or back side) and attached to the insulating material layer 103. The second metal layer 105 is disposed on an opposite side of the insulating material layer 103 (such as its upper or front side) and attached to the insulating material layer 103. In some embodiments, the first metal layer 101 and the second metal layer 105 may be attached to the insulating material layer 103 by, for example, but not limited to, sintering, brazing, soldering, or bonding agents.

In some embodiments, the insulating material layer 103 may include a ceramic material. The first and second metal layers may be formed from, for example, copper (Cu) or aluminum (Al) or other suitable metal materials. In an embodiment of the present disclosure, the multilayer substrate may be one of: a DBC substrate, an Active Metal Braze (AMB) substrate, a Direct Bonding Aluminum (DBA) substrate, or an Insulated Metal Substrate.

As shown in FIG. 1, the insulating material layer 103 can be configured in the form of a plurality of segments separated from each other. Four segments 1031, 1032, 1033, and 1034 are illustratively shown in the figure. However, this disclosure is not intended to be limited thereto and may include more or fewer segments, such as two or more segments. Those segments are separated from each other by gaps (e.g. 1021).

The second metal layer 105 has a first portion 125, as shown in FIG. 2, which is the portion surrounded by a dashed box 121. Here, the dashed box schematically illustrates the outer contour of the insulating material layer 103. In addition, for the convenience of comparison, the dashed box 121 is also shown in FIG. 1. The first portion 125 of the second metal layer 105 overlaps at least one segment of the insulating material layer 103. A chip can be attached to the first portion 125 of the second metal layer 105. Preferably, the chip may be (but is not limited to) a die in which a power semiconductor device or other semiconductor devices are formed.

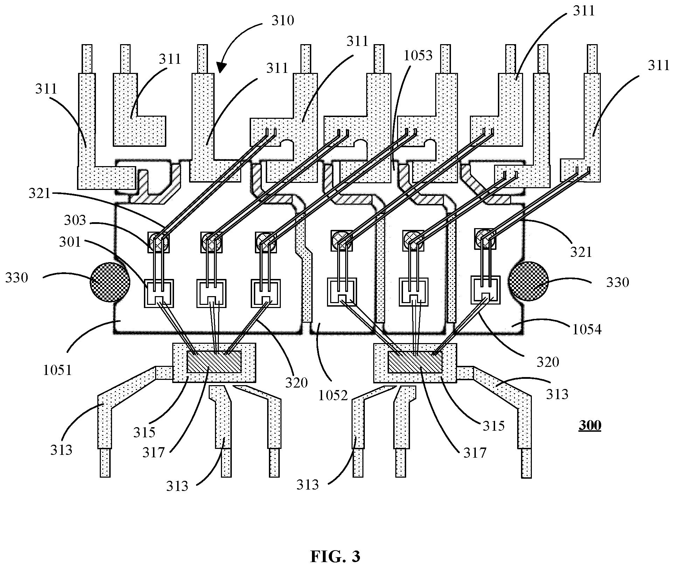

The second metal layer 105 further includes a second portion 127, as can be better seen from FIG. 2, which is the portion outside the dashed box 121. As shown in FIG. 2, the second portion 127 extends from the first portion 125 and extends beyond the insulating material layer 103. The second portion 127 may have at least one opening (first opening) 107. As will be discussed in more detail later, the opening 107 can be configured to have a shape matching the shape of a corresponding portion of a clamping tool (such as, the one indicated by positioning rods 330 in FIG. 3), such that the at least one first opening can firmly engage the clamping tool.

In the figure, as an example of the opening, two notches (first notches) 107 are shown. The notches 107 are respectively provided on opposite sides of the second metal layer 105 (e.g., the left and right sides thereof shown in FIG. 2) and extend inward from the edges of the second portion 127 of the second metal layer 105 (e.g., the left and right edges thereof shown in FIG. 2). In some embodiments, a projection of the opening 107 on a plane in which the insulating material layer 103 is located preferably does not overlap the insulating material layer 103. In other words, the inner edges 109 of the openings 107 are outside the insulating material layer 103, so that in the top view, the insulating material layer 103 is not exposed from the opening 107, as can be better seen in FIG. 1.

In some embodiments, the length direction of each segment 1031-1034 of the insulating material layer 103 can be set to be substantially parallel to the opposite sides of the second metal layer 105, as shown in the figures.

According to an embodiment of the present disclosure, by providing multiple segments separated from each other in the ceramic material layer, stress and strain in the multilayer substrate such as a DBC or AMB substrate can be reduced, and the influence of an increased temperature and increased pressure (for example, but not limited to, when bonding chips or leads) on the multilayer substrate under stress and strain can be reduced, thereby improving the reliability, robustness and durability of the module.

The opening 107 may be used to accommodate a fixing or clamping component, such as a positioning rod 330 as shown in FIG. 3, to fix or clamp the substrate 100. For example, in an encapsulation process, the substrate 100 may be fixed or clamped by positioning rod(s) 330 so that the substrate 100 remains stable when a molding compound (such as resin) is applied, so as to reduce swirling and overflow of the resin. In addition, the formation of blind holes can also be avoided. Preferably, as shown in the figures, the edge of the notch 107 of the first metal layer 101 which faces the internal side can be arc-shaped. In this way, the multilayer substrate can be clamped more firmly and the insulating material layer, such as a ceramic layer, can be prevented from being squeezed.

In some embodiments, the second metal layer 105 may comprise a plurality of segments separated from each other. As an example, a plurality of segments 1051, 1052, 1053, 1054, 1055, and 1057 are shown in FIGS. 1 and 2, for example, separated by gaps 1023. As shown in the figure, each segment of the second metal layer 105 is attached to corresponding segment(s) of the insulating material layer 103 to provide a firm and reliable securing. In addition, the size of each segment of the second metal layer 105 can be configured based on the size of the corresponding segment of the insulating material layer 103 to which it is attached.

Segments 1051, 1052, 1053, and 1054 may each include at least a portion of the first portion 125 of the second metal layer 105 and a portion extending from the portion. The main body (also referred to as chip attachment portion) of each segment 1051, 1052, 1053, or 1054 can be used to attach a chip (such as power chip) thereto, as shown in FIG. 3, and it can be at least a portion of the first portion 125 of the second metal layer 105. The portion extending from the main body of each segment 1051, 1052, 1053, or 1054 can be used for attaching a lead, as shown in FIG. 3, and therefore can be referred to as a lead attachment portion.

For the segment of relatively-small size of the second metal layer 105, such as the segments 1052, 1053, and 1054 (whose sizes can accommodate only one power chip attached thereto, as shown in FIG. 3), the main body of such a segment for attaching a chip thereto is attached to a corresponding segment of the insulating material layer 103, and the lead attachment portion thereof for lead attachment is attached to at least another different segment, thereby improving stability and further reducing the influence of the stress and strain. In the embodiments shown in FIGS. 2 and 3, the main bodies (or chip attachment portions) of segments 1052, 1053, and 1054 are attached to the segments 1032, 1033, and 1034 of the insulating material layer 103, respectively, while the lead attachment portions thereof are attached to the segment 1032 and the adjacent segment 1031, the segment 1032 and the adjacent segment 1033, the segment 1033 and the adjacent segment 1034 of the insulating material layer 103, respectively.

For the segment of large size of the second metal layer 105, such as the segment 1051 (which can accommodate multiple power chips attached thereto, as shown in FIG. 3), the size of the corresponding segment of the insulating material layer 103 to which it is attached is preferably set to be comparable to or fit to that of such segment the second metal layer 105. For example, the main body (for attaching power chip(s) thereto) and the lead portion (for attaching lead(s) thereto) of segment 1051 are configured to overlap the segment 1031, thereby providing stable support for the process steps of attaching chip and attaching lead. However, the present disclosure shall not be limited thereto. In other embodiments, the segment 1051 may be attached to two or more segments of the insulating material layer as needed.

In some embodiments, as shown in the figure, one or more of the plurality of segments of the second metal layer 105 respectively comprises at least a portion of the first portion 125 and at least a portion of the second portion 127. In addition, segments 1055 and 1057 are also shown in the figure without chips mounted thereon, but only used to provide electrical connections (e.g., electrical connections with leads as shown in FIG. 3).

It should be understood that the segments shown here are merely illustrative. For example, in some embodiments, the second metal layer 105 may have only a portion of the segments shown in the figure, such as having only the segment 1051, or having the segment 1051 and one or more of the segments1052-1057, or may have more additional other segment(s).

Furthermore, as shown in the figures, the first metal layer 101 is preferably integral. The first metal layer 101 may be separated from the second metal layer 105 by the insulating material layer 103 (segments 1031-1034) and gaps between the segments (e.g., air gaps or resin that may be filled later) . In this way, the first metal layer 101 and the second metal layer 105 can be electrically insulated from each other.

As shown in the figures, the first metal layer 101 may comprise: a first portion that overlaps the insulating material layer 103, such as the portion 115 between the dashed lines 121 in FIG. 1, and a second portion 117 extending from the first portion 115 and beyond the insulating material layer 103. Preferably, the second portion 117 of the first metal layer 101 has at least one opening (second opening) 109 extending inward from an edge of the second portion 117. In some embodiments, at least one of each first opening and the corresponding second opening may be configured to have a shape matching the shape of a corresponding portion of the clamping tool, such that it can firmly engage the clamping tool.

Preferably, a vertical projection of each opening 109 on a plane in which the second metal layer 105 is located overlaps a corresponding opening 107 of the second metal layer 105. In some embodiments, the at least one second opening 109 may include at least two notches (second notches) as shown in the figures. The notches 109 are disposed on opposite sides of the first metal layer 101 respectively. Preferably, a vertical projection of each notch 109 on a plane in which the second metal layer 105 is located overlaps a corresponding notch 107 of the second metal layer 105. The edge of the second notch of the second metal layer 105 towards the internal thereof may be arc-shaped, such as be a portion of a circular or elliptical shape. Preferably, at least one of each first notch and its corresponding second notch has a shape matching the shape of a corresponding portion of the clamping tool, such that the at least one notch can firmly engage the clamping tool. Preferably, a vertical projection of each second opening on a plane in which the second metal layer is located overlaps at least a portion of the corresponding first opening of the second metal layer for engaging the clamping tool. For example, the inner edge of the opening 109 overlaps the inner edge of the opening 107, as shown in the figures. In this way, the multilayer substrate can be clamped more firmly.

Although FIGS. 1 and 2 schematically illustrate notches in an arc shape (such as a portion of a circular or elliptical shape), this is not intended to be a limitation. The notch according to the embodiments of the present disclosure may have any shape suitable for fitting and fixing the clamping component. Preferably, the shape of the notch should be suitable for clipping the clamping component in and allow for some certain error margin.

In some embodiments, a width of the open edge of the first notch is greater than a width of an inner portion of the first notch in a direction parallel to the open edge, and a width of the open edge of the second notch is greater than a width of an inner portion of the second notch in a direction parallel to the open edge.

In other embodiments, a width of the open edge of the first notch is less than a width of at least a portion of an inner portion of the first notch in a direction parallel to the open edge, and a width of an open edge of the second notch is less than a width of at least a portion of an inner portion of the second notch in a direction parallel to the open edge.

In some embodiments, the first notch comprises two inner edges extending inward facing each other, and the second notch comprises two inner edges extending inward facing each other. Each inner edge of the first and second notches is configured such that: with respect to an axis passing through an innermost point of the inner edge and parallel to a direction in which the respective notch extends inward, the inner edge has a slope gradually decreasing as the inner edge extends toward the innermost point.

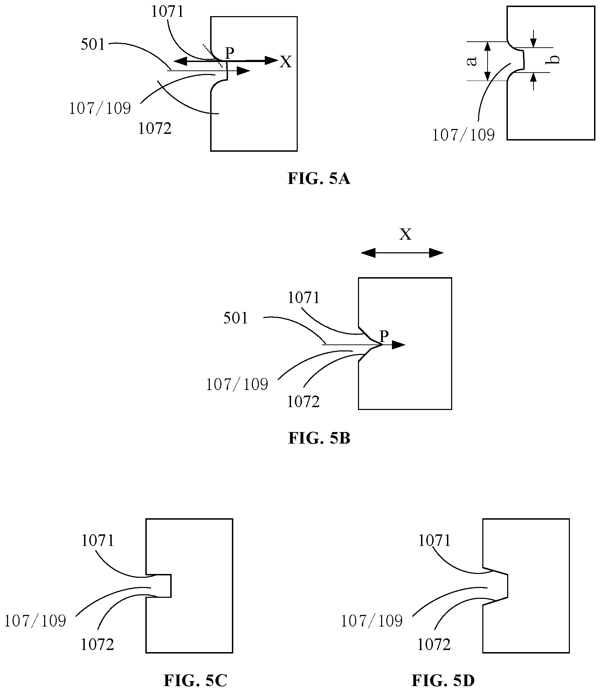

In some embodiments, each inner edge has one of the following shapes: an arch which is not continuously differentiable; and a plurality of line segments connected in sequence and having discontinuous slopes. In some embodiments, the inner edges of the first notch of the first metal layer are arc-shaped, and the inner edges of the second notch of the second metal layer are arc-shaped. In some embodiments, the first notch of the first metal layer is a portion of a circle or ellipse, and the second notch of the second metal layer is a portion of a circle or ellipse. Or in some embodiments, the first notch is a trapezoid, a square, a rectangle, or a combination thereof, and the second notch is a trapezoid, a square, a rectangle, or a combination thereof. FIGS. 5A-5D are schematic diagrams showing the shapes of a notch according to some embodiments of the present disclosure. As shown in FIG. 5A, the two edges 1071 and 1072 of the notch 107/109 face each other and extend inward (i.e., toward the interior of the corresponding metal layer). As shown in FIG. 5A, the width a of the open edge of the notch 107/109 can be set to be greater than the width b of an inner portion of the notch in a direction parallel to the open edge, as shown in the figure on the right side of FIG. 5A. In some embodiments, the two edges of the notch 107/109 extend inward facing each other, and the distance between the two edges gradually decreases as they extend inward. In other words, the distance between the two edges gradually decreases in a first direction toward the interior of the corresponding metal layer (e.g. as indicated by the arrow 501 in the figure). As an example, the first direction can be the horizontal direction (X direction) in the figure. However, the present disclosure shall not be limited to this.

In some embodiments, the edges of the notch 107/109 (such as 1071 and 1072) may each be configured such that with respect to an axis passing through an innermost point (such as point P) of the edge and parallel to a direction (e.g., X direction in the figure) in which the notch extends inward, the edge has a slope (as indicated by a tangent line shown as a dashed line in the figure) that gradually decreases as the edge extends toward the innermost point. Preferably, each edge can be in the shape of an arc which is not continuously differentiable. For example, the arc may include multiple segments connected one with another, which are not continuously differentiable between the segments.

FIG. 5B is a schematic diagram showing the shape of a notch according to other embodiments of the present disclosure. As shown in FIG. 5B, the width of an open edge of the notch 107/109 can be set to be greater than the width of an inner portion of the notch in a direction parallel to the open edge. In a preferred embodiment, with respect to an axis passing through an innermost point (such as point P) of the edge and parallel to a direction (e.g., the X direction in the figure) in which the notch extends inward, the edge has a slope that gradually decreases as the edge extends toward the innermost point. In a preferred embodiment, each edge may include a plurality of line segments with discontinuous slopes, which are connected in sequence.

On the one hand, in some embodiments, the distance between the two edges of the notch at the outermost part of the notch is larger than a corresponding width of the clamping component, which makes it easier for the clamping component to find the notch and clamp in. The distance between the two edges at the innermost part of the notch is less than or equal to the width of the clamping component. This allows the clamping component to be naturally engaged at a position where the distance between the two edges matches the width of the clamping component when clamping the clamping component into the notch, thereby enabling the clamping component to grip the multilayer substrate more stably, thereby reducing or eliminating the shaking or shifting of the clamped multilayer substrate when a molding compound is applied.

In some embodiments, the first notch may be a portion of a circle or ellipse, and the second notch of the second metal layer may be a portion of a circle or ellipse. In some embodiments, the notch may be half of a circle or ellipse. In some embodiments, the notch may be more than half of a circle or ellipse.

In some embodiments, the first notch is a trapezoid, a square, a rectangle, or a combination thereof, and the second notch is a trapezoid, a square, a rectangle, or a combination thereof, as shown in FIGS. 5C and 5D.

Configuring the opening(s) of the present disclosure into the shape as described above can bring about improvements in the use of the opening. It allows the clamping component to naturally engage at a position where the distance between the two edges matches the width of the clamping component when clamping the claiming component(s) into the opening(s), thereby enabling the clamping component to grip the multilayer substrate more stably, thereby reducing or eliminating the shaking or shifting of the clamped multilayer substrate when a molding compound is applied.

In some embodiments, the size of the first metal layer 101 in a direction (such as the vertical direction in the figure) different from the opposite sides described above (such as the horizontal direction) can be set to be smaller than the size of the insulating material layer 103 (and its segments), and also be smaller than the size of the second metal layer 105 in that direction, as shown in FIGS.1 and 2.

FIG. 3 shows a schematic diagram of a power module according to some embodiments of the present disclosure. As shown in FIG. 3, a module 300 may include a multilayer substrate as described in any embodiment of the present disclosure. The module 300 may also include chips 301 and/or 303. The chip 301 may be, for example but not limited to, a power chip containing power semiconductor devices. The optional chip 303 may be a cooperative chip containing devices (such as diodes) that cooperate with the power devices. The chips may be attached to the first portion of the second metal layer 105 of the substrate, such as the main bodies of the respective segments.

The module 300 may also include a lead frame 310. As shown in FIG. 3, the lead frame may include one or more leads, such as leads 311, respectively attached to (and thus electrically connected to) corresponding segments 1051-1057 of the second metal layer 105. The lead frame may include one or more leads 313 and chip attachment areas 315 for attaching, for example, control chips 317. As an example, FIG. 3 illustrates two chip attachment areas 315 and two controller chips 317.

The power chips 301 may be electrically connected to the cooperative chips 303 via wires 321 and connected to corresponding leads 311. The control chips 317 can be coupled to the power chips via the wires 320 and to the leads 313 via wires (not shown). The leads 311 and 313 can be electrically connected to external components or other components of the module.

After attaching chips (such as power chip(s), cooperative chip(s), and control chip(s)) to the multilayer substrate and the lead frame, a molding process can be performed. The multilayer substrate may be firmly held in place by clamping tools or fasteners (such as clamping bars, including positioning rods 330), and a molding compound (such as a liquid resin) may be applied to encapsulate, for example, a portion of the multilayer substrate, the chips, a portion of the lead frame, and wires.

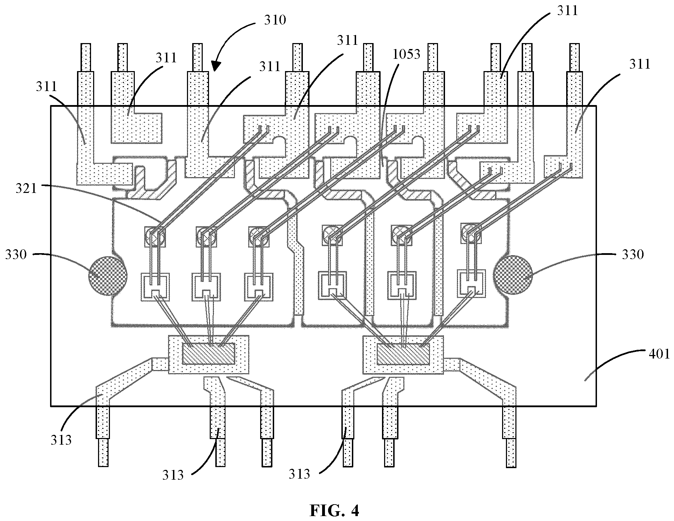

FIG. 4 shows a schematic diagram of a power module according to some embodiments of the present disclosure. FIG. 4 comprises all the components shown in FIG. 3 and shows a mold compound 401. The mold compound 401 encapsulates a portion of the multilayer substrate, the chips, a portion of the lead frame, and the wires, etc. Preferably, the mold compound exposes a surface of the first metal layer 101 of the substrate away from the chips to facilitate heat dissipation. Thereafter, the clamping tools or fasteners (such as positioning rods 330) can be removed.

After the clamping tools or fasteners (such as positioning rods 330) are removed, holes may be left in the mold compound that overlap the first and/or second notches and can be used to install screws (not shown). Screws can pass through the holes and corresponding first and/or second notches.

An electrical system is also contemplated that may include a power module according to any embodiments of the present disclosure. As an example, the electrical system may include, for example, an inverter, a new energy vehicle, a wind power system, a solar power system, an energy storage system, or any other device or system to which the power module of the present disclosure may be applied or required.

Those skilled in the art will appreciate that the boundaries between the above-described operations (or steps) are merely illustrative. Multiple operations may be combined into a single operation, a single operation may be distributed in additional operations, and the execution of the operations may at least partially overlap in time. Moreover, alternative embodiments may include multiple instances of a particular operation, and the order of operations may be altered in other embodiments. However, other modifications, changes and substitutions are possible. Accordingly, the specification and drawings shall be regarded as illustrative rather than restrictive.

Although some specific embodiments of the present disclosure have been described in detail by way of example, those skilled in the art would readily understand that the above examples are only for the purpose of illustration and are not intended to limit the scope of the present disclosure. The various embodiments disclosed herein can be combined arbitrarily without departing from the spirit and scope of this disclosure. Those skilled in the art will also understand that various modifications can be made to the embodiments without departing from the scope and spirit of the disclosure. The scope of the disclosure is defined by the following claims.

## Claims

1. A multilayer substrate comprising:
an insulating material layer including a ceramic material;
a first metal layer attached to the insulating material layer on a side of the insulating material layer; and
a second metal layer attached to the insulating material layer on an opposite side of the insulating material layer;
wherein the insulating material layer is configured as a plurality of segments separated from each other; and
wherein a first portion of the second metal layer, for attaching a chip thereon, overlaps at least one of the plurality of segments of the insulating material layer.

2. The substrate according to claim 1, wherein the second metal layer further comprises:
a second portion extending from the first portion and beyond the insulating material layer, the second portion having at least one first opening;
wherein a projection of the at least one first opening on a plane in which the insulating material layer is located does not overlap the insulating material layer; and
wherein the at least one first opening has a shape matching a shape of a corresponding portion of a clamping tool such that the at least one first opening is capable of firmly engaging the clamping tool.

3. The substrate according to claim 2, wherein the at least one first opening comprises at least two first notches extending inward from edges of a second portion of the second metal layer and located on two opposite sides of the second metal layer respectively;
wherein length directions of the plurality of segments of the insulating material layer are substantially parallel to the two opposite sides of the second metal layer.

4. The substrate according to claim 1, wherein:
the second metal layer comprises a plurality of segments separated from each other;
wherein one or more of the plurality of segments of the second metal layer each comprise a chip attachment portion as at least a portion of the first portion and a lead attachment portion extending from the chip attachment portion; and
wherein each of the plurality of segments of the second metal layer is attached to a corresponding one of the plurality of segments of the insulating material layer.

5. The substrate according to claim 4, wherein the chip attachment portion is attached to a corresponding one of the plurality of segments of the insulating material layer, and the lead attachment portion is attached to the corresponding one of the plurality of segments and another adjacent one of the plurality of segments.

6. The substrate according to claim 1, wherein the first metal layer comprises:
a first portion overlapping the insulating material layer; and
a second portion extending from the first portion and beyond the insulating material layer, the second portion having at least one second opening extending inward from an edge of the second portion;
wherein at least one of both of each first opening and a corresponding second opening has a shape matching a shape of a corresponding portion of a clamping tool, such that it is capable of firmly engaging the clamping tool.

7. The multilayer substrate according to claim 6, wherein a vertical projection of each second opening on a plane in which the second metal layer is located overlaps at least a portion of a corresponding first opening of the second metal layer for engaging the clamping tool.

8. The substrate according to claim 6, wherein the at least one second opening comprises at least two second notches that are disposed on opposite sides of the first metal layer respectively;
wherein a vertical projection of each second notch on a plane in which the second metal layer is located falls in a corresponding first notch of the second metal layer; and
wherein at least one notch of both of each first notch and a corresponding second notch has a shape matching the shape of the corresponding portion of the clamping tool, such that the at least one notch is capable of firmly engaging the clamping tool.

9. The substrate according to claim 6, wherein the first metal layer is integral and is isolated from the second metal layer.

10. The substrate according to claim 8, wherein a width of an open edge of the first notch is greater than a width of an inner portion of the first notch in a direction parallel to the open edge; and
wherein a width of an open edge of the second notch is greater than a width of an inner portion of the second notch in a direction parallel to the open edge.

11. The substrate according to claim 8, wherein a width of an open edge of the first notch is less than a width of at least a portion of an inner portion of the first notch in a direction parallel to the open edge; and
wherein a width of an open edge of the second notch is less than a width of at least a portion of an inner portion of the second notch in a direction parallel to the open edge.

12. The substrate according to claim 8, wherein the first notch comprises two inner edges extending inward facing each other;
wherein the second notch comprises two inner edges extending inward facing each other; and
wherein each inner edge of the first notch and the second notch is configured such that, with respect to an axis passing through an innermost point of the inner edge and parallel to a direction in which the respective notch extends inward, the inner edge has a slope gradually decreasing as the inner edge extends toward the innermost point.

13. The substrate according to claim 12, wherein each inner edge has one of the following shapes:
an arc which is not continuously differentiable; or
a plurality of line segments connected in sequence and having discontinuous slopes.

14. The substrate according to claim 12, wherein the inner edges of the first notch of the first metal layer are arc-shaped, and the inner edges of the second notch of the second metal layer are arc-shaped.

15. The substrate according to claim 12, wherein:
the first notch is a portion of a circle or ellipse and the second notch is a portion of a circle or ellipse; or
the first notch is a trapezoid, a square, a rectangle, or a combination thereof, and the second notch is a trapezoid, a square, a rectangle, or a combination thereof.

16. A power module comprising:
a substrate comprising:
an insulating material layer including a ceramic material;
a first metal layer attached to the insulating material layer on a side of the insulating material layer; and
a second metal layer attached to the insulating material layer on an opposite side of the insulating material layer;
wherein the insulating material layer is configured as a plurality of segments separated from each other; and
wherein a first portion of the second metal layer, for attaching a chip thereon, overlaps at least one of the plurality of segments of the insulating material layer; and
the chip including a power semiconductor device;
wherein the chip is attached to the first portion of the second metal layer of the substrate.

17. The power module according to claim 16, further comprising:
a lead frame comprising a lead attached to the second metal layer; and
a mold compound encapsulating at least a portion of the substrate, the chip, and at least a portion of the lead frame;
wherein a portion of the second metal layer having the lead attached thereto is attached to a corresponding one of the plurality of segments of the insulating material layer; and
wherein the mold compound exposes a surface of the first metal layer of the substrate which is away from the chip.

18. The power module according to claim 16, wherein the second metal layer of the substrate further comprises a second portion extending from the first portion and beyond the insulating material layer, the second portion having at least one first opening;
wherein a projection of the at least one first opening on a plane in which the insulating material layer is located does not overlap the insulating material layer; and
wherein the at least one first opening has a shape matching a shape of a corresponding portion of a clamping tool such that the at least one first opening is capable of firmly engaging the clamping tool.

19. The power module to claim 18, wherein the at least one first opening of the second portion of the second metal layer of the substrate comprises at least two first notches extending inward from edges of a second portion of the second metal layer and located on two opposite sides of the second metal layer respectively; and
wherein length directions of the plurality of segments of the insulating material layer are substantially parallel to the two opposite sides of the second metal layer.

20. An electrical system comprising:
a power module comprising:
a substrate comprising:
an insulating material layer including a ceramic material;
a first metal layer attached to the insulating material layer on a side of the insulating material layer; and
a second metal layer attached to the insulating material layer on an opposite side of the insulating material layer;
wherein the insulating material layer is configured as a plurality of segments separated from each other;
wherein a first portion of the second metal layer, for attaching a chip thereon, overlaps at least one of the plurality of segments of the insulating material layer; and
wherein the chip includes a power semiconductor device; and
wherein the chip is attached to the first portion of the second metal layer of the substrate.
